# EUROPÄISCHE PATENTSCHRIFT

(11) **EP 3 222 064 B1**
(45) Veröffentlichungstag und Bekanntmachung des Hinweises auf die Patenterteilung: **01.04.2020**
(21) Anmeldenummer: 15816071.3
(22) Anmeldetag: 16.11.2015
(51) Int. Cl.: H04W 4/70, H04L 29/08, H04W 4/38, H01L 33/00, H05B 37/02, F21V 23/00, H05B 33/08, H04W 84/18

(54) **LEUCHTMITTEL, SYSTEM UND KOMMUNIKATIONSVERFAHREN**
ILLUMINATING MEANS, SYSTEM AND COMMUNICATION METHOD
MOYEN D'ÉCLAIRAGE, SYSTÈME ET PROCÉDÉ DE COMMUNICATION

(30) Priorität: 20.11.2014 DE 102014223730; 02.02.2015 AT 252015 U
(43) Veröffentlichungstag der Anmeldung: 27.09.2017
(73) Patentinhaber: Tridonic GmbH & Co. KG, 6851 Dornbirn (AT)
(72) Erfinder: JUEN, Reinhold, A-6850 Dornbirn (AT)
(74) Vertreter: Banzer, Hans-Jörg
(86) Internationale Anmeldenummer: PCT/AT2015/050294
(87) Internationale Veröffentlichungsnummer: WO 2016/077856

(56) Entgegenhaltungen:
- US-A1- 2010 141 153
- US-A1- 2014 273 892

## Beschreibung

Die Erfindung betrifft ein Leuchtmittel, ein System und ein Verfahren zur Kommunikation zwischen einem Endgerät und einem Drahtlosnetz.

Der Bedarf, Kommunikation zwischen Endgeräten und Netzwerken zu ermöglichen, nimmt beständig zu. Unter dem Begriff Internet der Dinge ("Internet of Things", IoT) werden Techniken zusammengefasst, bei denen nicht nur Kommunikationsendgeräte wie Telefone oder Computer, sondern auch Sensoren, Haushaltsgeräte oder andere elektrische oder elektronische Einheiten mit einem Netzwerk, insbesondere dem Internet, in Kommunikationsverbindung treten können.

Um eine derartige Kommunikation zwischen Endgeräten wie Sensoren, Haushaltsgeräten oder anderen Geräten für den Heimgebrauch, und einem Netzwerk zu ermöglichen, muss eine Infrastruktur bereitgestellt werden, die die Übertragung von Daten ermöglicht. Eine Möglichkeit zur Bereitstellung einer derartigen Infrastruktur besteht darin, Geräte zu installieren, die nur Kommunikationsaufgaben aufweisen und beispielsweise als Zugangspunkte für ein Drahtlosnetz wirken. Die Installation derartiger zweckgebundener Geräte kann jedoch nicht nur im Hinblick auf die Kosten der Geräte selbst, sondern auch im Hinblick auf die Installationskosten, die Wartungskosten und den Bauraum nachteilig sein.

Die Druckschrift US 2010/141153 A1 offenbart ein Leuchtmittel mit den Merkmalen des Oberbegriffs des Patentanspruchs 1.

Es besteht ein Bedarf an Vorrichtungen, Systemen und Verfahren, die eine Kommunikation zwischen einem Endgerät und einem Drahtlosnetz ermöglichen. Es besteht insbesondere ein Bedarf an derartigen Vorrichtungen, Systemen und Verfahren, die wenigstens einige der Nachteile vermeiden, die mit der Installation einer Vielzahl von Geräten, die nur für Kommunikationszwecke ausgestaltet sind und Knoten eines Drahtlosnetzes bilden, verbunden sind.

Diese Aufgabe wird gelöst durch ein Leuchtmittel mit den Merkmalen des Anspruchs 1, ein System mit den Merkmalen des Anspruchs 7 und ein Verfahren mit den Merkmalen des Anspruchs 10. Die Merkmale der abhängigen Ansprüche definieren bevorzugte und vorteilhafte Ausführungsbeispiele.

Nach Ausführungsbeispielen wird vorgesehen, dass ein LED-Modul, eine LED-Lampe, beispielsweise ein so genanntes LED-Retrofit, die auch als LED-Austauschlampe bezeichnet wird, oder ein anderes Leuchtmittel eingerichtet ist, um die Funktion eines Zugangspunkts für ein Drahtlosnetz zur Verfügung zu stellen.

Dadurch wird ausgenutzt, dass künstliche Beleuchtung in Gebäuden, aber auch in anderen Flächen des städtischen Lebens weit verbreitet ist. Durch die Ausgestaltung von Leuchtmitteln derart, dass sie als Knoten eines Drahtlosnetzes wirken können, kann die Infrastruktur bereitgestellt werden, die für eine Kommunikation zwischen dem Endgerät und dem Internet nötig ist.

Die Erfindung wird nachfolgend unter Bezugnahme auf die beigefügte Zeichnung anhand bevorzugter Ausführungsbeispiele näher erläutert.
Figur 1 zeigt ein Leuchtmittel nach einem Ausführungsbeispiel.
Figur 2 zeigt ein Leuchtmittel nach einem Ausführungsbeispiel.
Figur 3 zeigt ein Leuchtmittel nach einem Ausführungsbeispiel.
Figur 4 zeigt ein System mit einem Leuchtmittel nach einem Ausführungsbeispiel.
Figur 5 zeigt ein Drahtlosnetz, das wenigstens ein Leuchtmittel nach einem Ausführungsbeispiel umfasst.
Figur 6 ist ein Blockdiagramm eines Leuchtmittels nach einem Ausführungsbeispiel.
Figur 7 ist ein Flussdiagramm eines Verfahrens nach einem Ausführungsbeispiel.

Die Erfindung wird nachfolgend anhand von Ausführungsbeispielen unter Bezugnahme auf die Figuren näher beschrieben, in denen identische Bezugszeichen identische oder korrespondierende Elemente repräsentieren. Die Merkmale verschiedener Ausführungsbeispiele können miteinander kombiniert werden, sofern dies in der Beschreibung nicht ausdrücklich ausgeschlossen wird. Auch wenn einige Ausführungsbeispiele im Kontext spezifischer Anwendungen, beispielsweise im Kontext von LED-Modulen, näher beschrieben werden, sind die Ausführungsbeispiele nicht auf diese Anwendungen beschränkt.

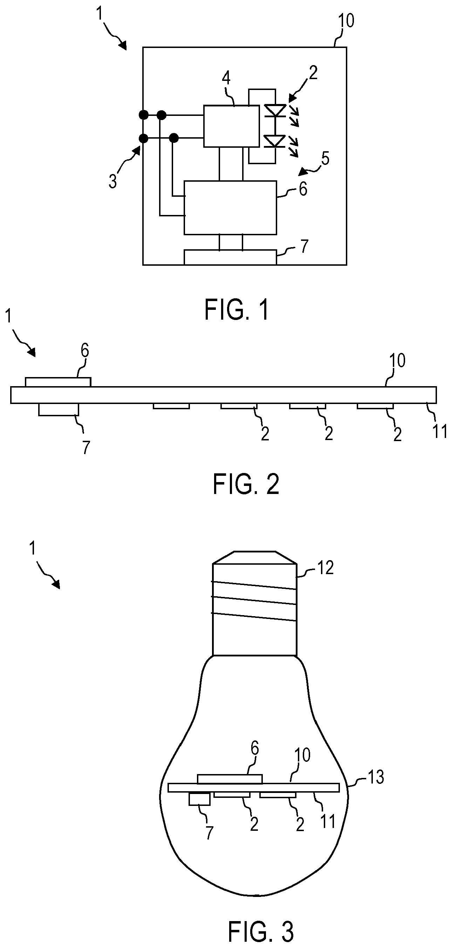

Figur 1 ist eine Darstellung eines Leuchtmittels 1 nach einem Ausführungsbeispiel. Das Leuchtmittel kann ein LED-Modul 1 oder eine LED-Lampe 1, beispielsweise eine LED-Austauschlampe, sein. Das Leuchtmittel umfasst eine Leuchtdiode (LED) oder mehrere LEDs 2. Die LED oder die LEDs können anorganische Leuchtdioden, organische Leuchtdioden oder eine Kombination von anorganischen Leuchtdioden und organischen Leuchtdioden umfassen. Die LEDs können in einer oder mehreren LED-Strecken kombiniert oder auf andere Weise verschaltet sein. Das Leuchtmittel 1 kann optional eine Treiberschaltung 4 umfassen. Die Treiberschaltung 4 kann einen Gleichstrom/Gleichstrom (DC/DC)-Wandler umfassen. Ein Eingang 3 kann mit einer Versorgungsquelle gekoppelt sein. Beispielsweise kann der Eingang 3 für eine Verbindung mit einem LED-Konverter eingerichtet sein. Bei einer LED-Lampe kann der Eingang 3 für eine direkte Verbindung mit einer Netzspannung eingerichtet sein.

Das Leuchtmittel 1 umfasst eine Kommunikationseinrichtung 5. Die Kommunikationseinrichtung 5 dient zur drahtlosen Kommunikation. Die Kommunikationseinrichtung 5 kann eingerichtet sein, um Daten von einem Endgerät zu empfangen und/oder zu einem Endgerät zu senden. Das Endgerät kann beispielsweise ein Endgerät vom Maschinentyp sein, z.B. ein Sensor oder ein Haushaltsgerät, sein.

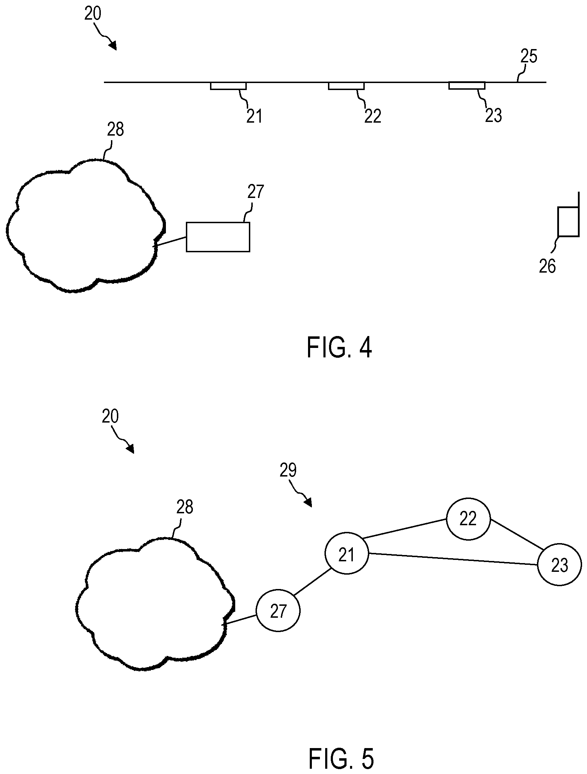

Die Kommunikationseinrichtung 5 umfasst eine Funkschnittstelle mit einer Antenne 6. Die Kommunikationseinrichtung 5 kann eine integrierte Halbleiterschaltung oder mehrere integrierte Halbleiterschaltungen 6 umfassen. Die wenigstens eine integrierte Halbleitschaltung kann als Controller, Mikrocontroller, Prozessor, Mikroprozessor, anwendungsspezifische Spezialschaltung oder eine Kombination davon gebildet sein. Die wenigstens eine integrierte Halbleiterschaltung 6 kann eingerichtet sein, um Aufgaben des Protokollstapels für die drahtlose Kommunikation über die Funkschnittstelle auszuführen. Derartige Aufgaben können ein Weiterleiten von Paketen, beispielsweise auf IP-Ebene, umfassen. Derartige Aufgaben können auch eine Fehlerüberprüfung, eine Fehlerkorrektur und/oder eine Weiterverarbeitung der empfangenen Daten umfassen. Die wenigstens eine integrierte Halbleiterschaltung 6 kann eingerichtet sein, um empfangene Daten über die Funkschnittstelle 31 weiterzusenden.
Die Kommunikationseinrichtung 5 kann eingerichtet sein, um die Funktion eines Zugangspunkts eines Drahtlosnetzes zu erfüllen. Diese Funktion kann in das Leuchtmittel 1 integriert sein. Die Kommunikationseinrichtung 5 kann eingerichtet sein, um mit einem weiteren Knoten oder mehreren weiteren Knoten des Drahtlosnetzes zu kommunizieren. Wenigstens ein Knoten des Drahtlosnetzes kann eine Anbindung an ein Weitverkehrsnetz, beispielsweise das Internet, herstellen, wie unter Bezugnahme auf Figur 4 und Figur 5 noch ausführlicher beschrieben wird.

Verschiedene Kommunikationsschnittstellen können in dem Leuchtmittel 1 integriert sein. Das Leuchtmittel 1 kann so eingerichtet sein, dass es eine Kommunikation über ein drahtloses Lokalnetz (WLAN) ermöglicht. Das Leuchtmittel 1 kann für eine WLAN-Kommunikation gemäß einem Standard der IEEE 802.11-Standardfamilie eingerichtet sein. Das Leuchtmittel 1 kann für eine WLAN-Kommunikation gemäß IEEE 802.11s für drahtlose vermaschte Netze eingerichtet sein. Das Leuchtmittel 1 kann für eine Kommunikation gemäß WiFi-Spezifikationen eingerichtet sein. Die Kommunikationseinrichtung 5 kann eingerichtet sein, um Signale zu empfangen und zu senden, die gemäß IEEE 802.11s-2011 erzeugt werden. Alternativ oder zusätzlich kann das Leuchtmittel 1 eingerichtet sein, um Signale zu empfangen und zu senden, die gemäß 3GPP TR 22.803 und/oder 3GPP TR 23.703 erzeugt werden.

Die Kommunikationseinrichtung 5 kann eingerichtet sein, um Daten zwischen einem Endgerät und wenigstens einem weiteren Knoten eines Netzwerks weiterzuleiten. Dazu kann die Kommunikationseinrichtung 5 ein an der Funkschnittstelle von einem Endgerät empfangenes Signal verarbeiten, um zu ermitteln, ob die in dem Signal enthaltenen Daten weitergeleitet werden sollen. Die Kommunikationseinrichtung 5 kann wenigstens Nutzdaten, die von dem Endgerät empfangen werden, an einen weiteren Knoten eines Drahtlosnetzes weiterleiten. Falls einer der Knoten des Drahtlosnetzes eine Anbindung an das Internet aufweist, können die Daten über das Leuchtmittel 1 zwischen dem Endgerät und dem Internet weitergeleitet werden. Kontrollinformation, beispielsweise wenigstens eine Adresse, können von der Kommunikationseinrichtung 5 beim Weiterleiten modifiziert werden.
Alternativ oder zusätzlich kann die Kommunikationseinrichtung 5 ein an der Funkschnittstelle von einem Weitverkehrsnetz empfangenes weiteres Signal verarbeiten, um zu ermitteln, ob die in dem weiteren Signal enthaltenen Daten an ein Endgerät weitergeleitet werden sollen. Die Kommunikationseinrichtung 5 kann wenigstens Nutzdaten, die von dem Weitverkehrsnetz empfangen werden, an das Endgerät weiterleiten.

Die Funkschnittstelle des Leuchtmittels 1 kann nicht nur verwendet werden, um die Infrastruktur für eine Kommunikation zwischen einem Endgerät und einem Netzwerk bereitzustellen. Die Funkschnittstelle des Leuchtmittels 1 kann auch verwendet werden, um eine Steuerung des Leuchtmittels 1 und/oder eine Statusabfrage zu ermöglichen.

Beispielsweise kann die Kommunikationseinrichtung 5 eingerichtet sein, um ein an der Funkschnittstelle empfangenes Signal auszuwerten, um zu ermitteln, ob es sich dabei um ein Steuersignal für das Leuchtmittel 1 handelt. Ein an der Funkschnittstelle empfangenes Steuersignal kann umgesetzt werden, um eine Farbe, Helligkeit oder einen anderen Parameter, beispielsweise einen Dimmlevel, des Leuchtmittels zu steuern. Die Kommunikationseinrichtung 5 kann so eingerichtet sein, dass das Steuersignal an der Funkschnittstelle direkt von einem Endgerät empfangen werden kann, aber auch von wenigstens einem weiteren Knoten des Netzwerks an das Leuchtmittel 5 weitergeleitet werden kann. Beispielsweise kann auch eine Steuerung des Leuchtmittels 5 derart erfolgen, dass über ein Weitverkehrsnetz und ein daran angebundenes Drahtlosnetz das Steuersignal an das Leuchtmittel 1 gesendet wird.

Alternativ oder zusätzlich kann die Kommunikationseinrichtung 5 eingerichtet sein, um die Funkschnittstelle so zu steuern, dass Statusinformation gesendet wird. Die Statusinformation kann als Antwort auf eine Statusabfrage gesendet werden, die an der Funkschnittstelle empfangen wird. Das Leuchtmittel 1 kann so eingerichtet sein, dass die Statusinformation über wenigstens einen weiteren Knoten des Drahtlosnetzes an das Weitverkehrsnetz und/oder direkt an das Endgerät gesendet wird. Beispielsweise kann eine Statusabfrage des Leuchtmittels 5 derart erfolgen, dass die Statusinformation über wenigstens einen weiteren Knoten des Drahtlosnetzes an ein Weitverkehrsnetz gesendet wird. Die Statusinformation kann ausgewählt sein aus einer Gruppe bestehend aus Information über einen Fehlerfall, Temperaturinformation, Helligkeitsinformation oder Farbinformation.

Ein Senden von Statusinformation durch die Kommunikationseinrichtung 5 kann nicht nur durch eine externe Statusabfrage ausgelöst werden, sondern beispielsweise auch durch ein Erkennen eines Fehlers durch das Leuchtmittel 1.

Das Leuchtmittel kann unterschiedliche Ausgestaltungen aufweisen. Beispielhafte Ausgestaltungen werden unter Bezugnahme auf Figur 2 und Figur 3 näher beschrieben.

Figur 2 zeigt ein LED-Modul 1 nach einem Ausführungsbeispiel. Das LED-Modul 1 umfasst wenigstens eine LED 2 und eine Kommunikationseinrichtung, wie sie unter Bezugnahme auf Figur 1 erläutert wurde.

Eine LED 2 ist auf einer Oberfläche 11 einer Platine 10 angeordnet. Die Antenne 7 der Kommunikationsschnittstelle kann auf derselben Oberfläche 11 der Platine 10 angeordnet sein, auf der eine LED 2 angeordnet ist. Bei weiteren Ausgestaltungen kann die Antenne 7 auch auf einer Rückseite der Platine 10 angeordnet sein, die der Oberfläche 11 entgegengesetzt ist. Die wenigstens eine integrierte Halbleiterschaltung 6 kann ebenfalls auf der Oberfläche 11 angeordnet sein oder kann auf der zur Oberfläche 11 entgegengesetzten Oberfläche der Platine 10 angeordnet sein.

Figur 3 zeigt eine LED-Lampe 1 nach einem Ausführungsbeispiel. Die LED-Lampe 1 kann als so genannte LED-Austauschlampe ausgestaltet sein. Die LED-Lampe 1 kann einen Sockel 12 umfassen. Der Sockel 12 kann für eine lösbare Verbindung mit einer Fassung ausgestaltet sein, mit der die LED-Lampe 1 elektrisch kontaktiert und mechanisch gehalten wird. Der Sockel 12 kann ein Außengewinde umfassen. Der Sockel 12 kann ein E27-Sockel oder ein E14-Sockel sein. Der Sockel 12 kann ein Bajonettsockel sein.

Die LED-Lampe 1 umfasst wenigstens eine LED 2 und eine Kommunikationseinrichtung, wie sie unter Bezugnahme auf Figur 1 erläutert wurde. Eine Platine 10 mit wenigstens einer LED ist wenigstens teilweise von transluzentem Material 13 umgeben. Eine LED 2 ist auf einer Oberfläche 11 einer Platine 10 angeordnet. Die Antenne 7 der Kommunikationsschnittstelle kann auf derselben Oberfläche 11 der Platine 10 angeordnet sein, auf der eine LED 2 angeordnet ist. Bei weiteren Ausgestaltungen kann die Antenne 7 auch auf einer Rückseite der Platine 10 angeordnet sein, die der Oberfläche 11 entgegengesetzt ist. Die wenigstens eine integrierte Halbleiterschaltung 6 kann ebenfalls auf der Oberfläche 11 angeordnet sein oder kann auf der zur Oberfläche 11 entgegengesetzten Oberfläche der Platine 10 angeordnet sein.

Ein oder mehrere Leuchtmittel nach einem Ausführungsbeispiel können in einer Kommunikationsverbindung über ihre jeweilige Kommunikationseinrichtung stehen, um die Infrastruktur für ein drahtloses vermaschtes Netz bereitzustellen.

Figur 4 zeigt ein System 20 nach einem Ausführungsbeispiel. Mehrere Leuchtmittel 21, 22, 23, die jeweils eine Kommunikationseinrichtung umfassen, können an einer Decke 25, einer Wand oder an anderen Strukturelementen montiert sein.

Ein Endgerät 26 ist eingerichtet, um Signale an die Kommunikationsschnittstelle wenigstens eines der Leuchtmittel 21-23 zu senden. Das Endgerät 26 kann ein Endgerät vom Maschinentyp sein. Das Endgerät 26 kann ein Sensor, ein Haushaltsgerät oder ein anderes elektronisches oder elektrisches Gerät sein, das keine elektronische Benutzerschnittstelle umfasst. Das Endgerät 26 kann ein Gerät sein, das eine elektronische Benutzerschnittstelle umfasst, über die der Benutzer eine Kommunikation einleiten kann, wie dies beispielsweise bei einem Mobiltelefon oder einem Computer der Fall ist.

Das System 20 kann einen weiteren Knoten 27 umfassen, der für eine Drahtloskommunikation mit der Kommunikationseinrichtung wenigstens eines der Leuchtmittel 21-23 eingerichtet ist. Der Knoten 27 kann eine Anbindung an ein Weitverkehrsnetz 28 bereitstellen. Der Knoten 27 kann als Zugangspunkt für das Weitverkehrsnetz dienen. Das Weitverkehrsnetz 28 kann das Internet sein.

Im Betrieb können die Kommunikationseinrichtungen der Leuchtmittel 21-23 und optional der weitere Knoten 27 ein vermaschtes Netz bilden. Die Kommunikationseinrichtungen der Leuchtmittel 21-23 und optional der weitere Knoten 27 können ein Ad-hoc-Netz bilden. Das vermaschte Netz kann ein vermaschtes drahtloses Lokalnetz, das in der Technik auch als Mesh-WLAN bezeichnet wird, sein.

Im Betrieb kann eines der Leuchtmittel, beispielsweise das Leuchtmittel 23, Daten aus einem vom Endgerät 26 empfangenen Signal über die Funkschnittstelle an die Kommunikationseinrichtung wenigstens eines anderen Leuchtmittels 21, 22 weiterleiten. Die Daten können über einen oder mehrere Knoten des Drahtlosnetzes, von denen wenigstens einer durch die Kommunikationseinheit eines Leuchtmittels gebildet wird, zwischen dem Endgerät 26 und dem Weitverkehrsnetz 28 weitergeleitet werden. Dabei ist es nicht erforderlich, dass auch Kontrollinformation des Signals vom Endgerät 26 unverändert weitergeleitet wird. Beispielsweise können zur Weiterleitung zum Weitverkehrsnetz 28 jeweils Adressinformationen verändert werden, um Daten in dem Mesh-WLAN weiterzuleiten.

Über das Mesh-WLAN, das wenigstens eine Kommunikationseinrichtung eines Leuchtmittels umfasst, kann für das Endgerät 26 ein Zugangspunkt zu einem Netz bereitgestellt werden. Das Mesh-WLAN kann eingerichtet sein, um wenigstens eine unidirektionale Weiterleitung von Daten von dem Endgerät 26 zu dem Weitverkehrsnetz 28 zu ermöglichen. Das Mesh-WLAN kann eingerichtet sein, um eine bidirektionale Kommunikation zwischen dem Endgerät 26 und dem Weitverkehrsnetz 28 zu ermöglichen.

Figur 5 zeigt schematisch Verbindungen in einem System 20 nach einem Ausführungsbeispiel. Das System 20 umfasst ein Drahtlosnetz 29, das ein vermaschtes drahtloses Lokalnetz (Mesh-WLAN) sein kann. Die Kommunikationseinrichtungen von Leuchtmitteln 21-23 bilden wenigstens einen Teil der Knoten des Mesh-WLANs. Das Mesh-WLAN kann einen Knoten 29 umfassen, der mit dem Weitverkehrsnetz 28 verbunden ist und eine Kommunikation zwischen Knoten des Mesh-WLANs und dem Weitverkehrsnetz 28 ermöglicht. Das Weitverkehrsnetz 28 kann das Internet sein.

In dem Drahtlosnetz 29 kann jede Kommunikationseinrichtung eines Leuchtmittels mit wenigstens einem weiteren Knoten des Drahtlosnetzes 29 verbunden werden, wie durch die Verbindungslinien dargestellt ist. Die Kommunikationseinrichtung eines Leuchtmittels kann auch mit zwei oder mehr als zwei Knoten des Drahtlosnetzes 29 verbunden sein, um Daten von oder zu dem Endgerät 26 weiterzuleiten.

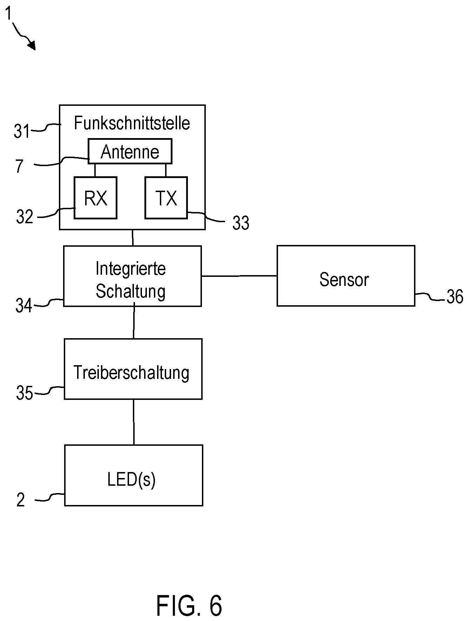

Figur 6 ist ein Blockdiagramm einer Vorrichtung nach einem Ausführungsbeispiel. Die Vorrichtung kann als LED-Modul, als LED-Lampe oder als ein anderes Leuchtmittel ausgestaltet sein.

Die Funkschnittstelle 31 umfasst eine Antenne 7. Die Antenne 7 kann zum Empfangen und/oder zum Senden von Funksignalen eingerichtet sein. Es können unterschiedliche Antennen zum Empfangen und Senden verwendet werden. Die Funkschnittstelle 31 kann einen Signalpfad 32 für empfangene Signale und einen weiteren Signalpfad 33 für zu sendende Signale umfassen. Der Signalpfad 32 kann eine Abtastung und optional eine Demodulierung von empfangenen Signalen vornehmen. Der weitere Signalpfad 33 kann eine Modulierung von Daten in Signale vornehmen.

Die Funkschnittstelle 31 kann für eine Kommunikation in einem WLAN-Frequenzbereich eingerichtet sein. Die Funkschnittstelle 31 kann zum Empfangen und Senden von Signalen im Frequenzband um 2,4 GHz und/oder im Frequenzband um 5 GHz eingerichtet sein. Die Antenne 13 kann zum Empfangen und Senden von Signalen im Frequenzbereich um 2,4 GHz und/oder im Frequenzbereich um 5 GHz eingerichtet sein. Die Antenne 13 kann zum Empfangen und Senden von Signalen im Frequenzbereich von 2,4 von 2,4835 GHz, im Frequenzbereich von 5,15 bis 5,35 GHz und/oder im Frequenzbereich von 5,47 bis 5,725 GHz eingerichtet sein.

Wenigstens eine integrierte Schaltung 34 kann mit der Funkschnittstelle 31 verbunden sein. Die wenigstens eine integrierte Schaltung 34 kann als Controller, Mikrocontroller, Prozessor, Mikroprozessor, anwendungsspezifische Spezialschaltung oder eine Kombination davon gebildet sein.

Die wenigstens eine integrierte Schaltung 34 kann Aufgaben eines Protokollstapels beim Senden und/oder Empfangen von Signalen ausführen. Beispielsweise kann die wenigstens eine integrierte Schaltung 34 eingerichtet sein, um Pakete auf IP-Ebene in einem vermaschten drahtlosen Netz weiterzuleiten.

Die wenigstens eine integrierte Schaltung 34 kann auch Funktionen ausführen, mit denen eine Helligkeit, eine Farbe und/oder ein anderer Parameter von von dem Leuchtmittel 1 abgegebenem Licht gesteuert oder geregelt wird. Beispielsweise kann die wenigstens eine integrierte Schaltung 34 eingerichtet sein, um einen steuerbaren Schalter einer Treiberschaltung 35 zu steuern. Die wenigstens eine integrierte Schaltung 34 kann eingerichtet sein, um die Treiberschaltung 35 so zu beeinflussen, dass eine gewünschte Helligkeit und/oder Farbe eingestellt wird.

Eine integrierte Halbleiterschaltung 34, beispielsweise ein Controller, kann sowohl Aufgaben der Steuerung oder Regelung der Treiberschaltung 35 als auch Aufgaben der Weiterleitung von Paketen in einem vermaschten drahtlosen Netz erfüllen.

Das Leuchtmittel 1 kann weitere Einheiten aufweisen. Beispielsweise kann ein Sensor oder können mehrere Sensoren 36 vorhanden sein. Die wenigstens eine integrierte Schaltung 34 kann eingerichtet sein, um Statusinformation abhängig von einem Ausgangssignals des Sensors oder der Sensoren 36 über die Funkschnittstelle 31 zu senden. Die Kommunikationseinrichtung, die die Funkschnittstelle 31 und die wenigstens eine integrierte Schaltung 34 umfassen kann, kann von der Versorgungsquelle mit Energie versorgt werden, die auch die Energieversorgung für die wenigstens eine Leuchtdiode 2 bereitstellt. Beispielsweise können die wenigstens eine integrierte Schaltung 34 und die Funkschnittstelle 31 mit demselben Versorgungseingang gekoppelt sein, der die Treiberschaltung 35 versorgt.

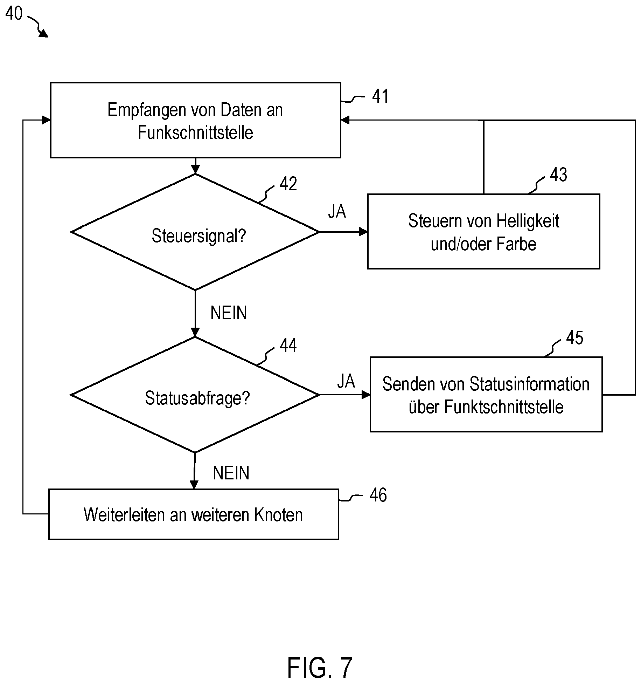

Figur 7 ist ein Flussdiagramm eines Verfahrens 40 nach einem Ausführungsbeispiel. Das Verfahren 40 kann von dem Leuchtmittel nach einem Ausführungsbeispiel automatisch ausgeführt werden.

Bei Schritt 41 kann das Leuchtmittel ein Signal an einer Funkschnittstelle empfangen. Das Signal kann ein Paket mit Daten umfassen.

Bei Schritt 42 kann überprüft werden, ob das empfangene Signal ein Steuersignal zum Ansteuern des Leuchtmittels ist. Dazu kann beispielsweise eine Adressinformation und/oder wenigstens ein Bit einer Steuerinformation des empfangenen Pakets ausgewertet werden. Das Steuersignal kann von einem Weitverkehrsnetz über das vermaschte Drahtlosnetz zu dem Leuchtmittel weitergeleitet werden. Das Steuersignal kann unmittelbar von einem Endgerät empfangen werden.

Falls das empfangene Signal ein Steuersignal ist, fährt das Verfahren bei Schritt 43 damit fort, eine Helligkeit, Farbe oder einen anderen Parameter abhängig von dem Steuersignal einzustellen. Es kann wenigstens ein Sollwert einer Regelschleife, mit der das Leuchtmittel Steuersignale für einen steuerbaren Schalter erzeugt, abhängig von dem Steuersignal eingestellt werden. Das Verfahren kann zu Schritt 41 zurückkehren.

Bei Schritt 44 kann überprüft werden, ob das empfangene Signal ein Steuersignal zum Ansteuern des Leuchtmittels ist. Dazu kann beispielsweise eine Adressinformation und/oder wenigstens ein Bit einer Steuerinformation des empfangenen Pakets ausgewertet werden. Falls das empfangene Signal ein Steuersignal ist, fährt das Verfahren bei Schritt 45 damit fort, Statusinformation zu senden. Die Statusinformation kann abhängig von einem Ausgangssignal eines Sensors oder abhängig von flüchtig oder nichtflüchtig in dem Leuchtmittel gespeicherten Daten erzeugt werden. Die Statusinformation kann ausgewählt sein aus einer Gruppe bestehend aus Information über einen Fehlerfall, Temperaturinformation, Helligkeitsinformation oder Farbinformation.

Das Senden von Statusinformation kann nicht nur durch eine Statusabfrage, die von extern an der Funkschnittstelle empfangen wird, ausgeführt werden, sondern kann beispielsweise auch durch das Erkennen eines Fehlerfalls durch das Leuchtmittel ausgelöst werden.

Falls das empfangene Signal Daten enthält, die zwischen dem Endgerät und einem Weitverkehrsnetz übertragen werden sollen, kann die Kommunikationseinrichtung bei Schritt 46 die Daten an wenigstens einen weiteren Knoten des Drahtlosnetzes weiterleiten. Die Kommunikationseinrichtung kann wenigstens Nutzdaten, die in einem an der Funkschnittstelle empfangenen Signal enthalten sind, unverändert an einen weiteren Knoten des Drahtlosnetzes weiterleiten. Die Nutzdaten, die unverändert weitergeleitet werden, können eine Adresse in einem Weitverkehrsnetz, beispielsweise eine IP-Adresse umfassen. Die Kommunikationseinrichtung kann Steuerinformation, die in dem an der Funkschnittstelle empfangenen Signal enthalten ist, bei der Weiterleitung an einen weiteren Knoten des Drahtlosnetzes verändern. Das Weiterleiten kann so erfolgen, dass Daten zwischen einem Endgerät und einem Weitverkehrsnetz über das Drahtlosnetz, das die Kommunikationseinrichtung des Leuchtmittels umfasst, weitergeleitet werden.

Während Vorrichtungen, Systeme und Verfahren nach Ausführungsbeispielen unter Bezugnahme auf die Figuren beschrieben wurden, können Abwandlungen bei weiteren Ausführungsbeispielen realisiert werden.

Während ein Leuchtmittel eine Kommunikationseinrichtung umfassen kann, die eingerichtet ist, um mit anderen Knoten eines vermaschten Drahtlosnetzes zu kommunizieren, kann das Leuchtmittel alternativ oder zusätzlich für eine Verwendung in anderen Netztypen eingerichtet sein.

Die Kommunikationseinrichtung eines Leuchtmittels muss nicht für eine Kommunikation nach einem IEEE 802.11-Standard eingerichtet sein, sondern kann auch andere Ausgestaltungen von Drahtlosschnittstellen verwenden.

Die Vorrichtungen, Systeme und Verfahren nach Ausführungsbeispielen können verwendet werden, um eine Kommunikation zwischen einem Endgerät und einem Weitverkehrsnetz zu ermöglichen. Bei weiteren Ausgestaltungen können die Vorrichtungen, Systeme und Verfahren nach Ausführungsbeispielen verwendet werden, um Daten nur innerhalb eines Lokalnetzes weiterzuleiten.

Vorrichtungen, Verfahren und Systeme nach Ausführungsbeispielen erlauben die Bereitstellung einer Infrastruktur, die Endgeräten einen Netzzugang ermöglicht, unter Verwendung von Vorrichtungen, die zur künstlichen Beleuchtung installiert werden.

## Patentansprüche

1. Leuchtmittel, umfassend
wenigstens eine Leuchtdiode (2),
eine Kommunikationseinrichtung (5), die eine Funkschnittstelle (31) für eine drahtlose Kommunikation mit einem Endgerät (26) umfasst, um einen Zugangspunkt eines Drahtlosnetzes (29) zu bilden, und
eine Steuereinrichtung (6; 34), die mit der Funkschnittstelle (31) verbunden ist,
wobei die Steuereinrichtung (6; 34) eingerichtet ist zum
- Ansteuern der Funkschnittstelle (31) zum Empfangen (41) eines Signals an der Funkschnittstelle (31),
- Prüfen (42), ob das empfangene Signal ein Steuersignal ist, und in diesem Fall Ansteuern (43) des Leuchtmittels (1) in Abhängigkeit von dem empfangenen Signal,
- Prüfen (44), ob das empfangene Signal eine Statusabfrage ist, und in diesem Fall Ansteuern der Funkschnittstelle (31) zum Senden (45) einer Statusinformation des Leuchtmittels (1) in Abhängigkeit von dem empfangenen Signal, und
- Prüfen, ob das empfangene Signal zwischen dem Endgerät (26) und einem Weitverkehrsnetz (28) zu übertragende Daten enthält, und in diesem Fall Ansteuern der Funkschnittstelle (31) zum Weiterleiten (46) der Daten an wenigstens einen weiteren Knoten (27) des Drahtlosnetzes (29).

2. Leuchtmittel nach Anspruch 1,
wobei das vermaschte Drahtlosnetz (29) ein vermaschtes drahtloses Lokalnetz ist.

3. Leuchtmittel nach Anspruch 1 oder Anspruch 2,
wobei die Kommunikationseinrichtung (5) eingerichtet ist, um die Daten an den wenigstens einen weiteren Knoten (27) des Drahtlosnetzes (29) so weiterzuleiten, dass die Daten zu einem Weitverkehrsnetz (28) weitergeleitet werden.

4. Leuchtmittel nach einem der vorhergehenden Ansprüche, umfassend
eine Platine (10),
wobei die Funkschnittstelle (31) eine Antenne (31) umfasst, die auf einer Oberfläche (11) der Platine (10) angeordnet ist, auf der eine Leuchtdiode (2) der wenigstens einen Leuchtdiode (2) angeordnet ist.

5. Leuchtmittel nach einem der vorhergehenden Ansprüche,
wobei die Steuereinrichtung (6; 34) eingerichtet ist, um eine Helligkeit und/oder eine Farbe von von dem Leuchtmittel (1) abgegebenen Licht abhängig von dem an der Funkschnittstelle (31) empfangenen Steuersignal zu steuern oder zu regeln.

6. Leuchtmittel nach einem der vorhergehenden Ansprüche,
wobei das Leuchtmittel (1) ein LED-Modul oder eine LED-Lampe ist.

7. System, umfassend
ein Drahtlosnetz (29) mit einer Mehrzahl von Knoten (21-23, 27), wobei wenigstens einer der Knoten (21-23) ein Leuchtmittel (1) nach einem der Ansprüche 1 bis 6 umfasst, und
ein Endgerät (26), das für eine Drahtloskommunikation mit der Funkschnittstelle (31) des Leuchtmittels (1) eingerichtet ist.

8. System nach Anspruch 7,
wobei das Drahtlosnetz (29) ein vermaschtes drahtloses Lokalnetz ist.

9. System nach Anspruch 7 oder Anspruch 8, umfassend
ein Weitverkehrsnetz (28),
wobei das Leuchtmittel (1) eingerichtet ist, um eine Kommunikation zwischen dem Endgerät (26) und dem Weitverkehrsnetz (28) zu ermöglichen.

10. Verfahren zur Kommunikation zwischen einem Drahtlosnetz (29) und einem Endgerät (26) oder einem Weitverkehrsnetz (28) unter Verwendung eines Leuchtmittels (1; 21), das wenigstens eine Leuchtdiode (2) und eine Kommunikationseinrichtung (5) mit einer Funkschnittstelle (31) für eine drahtlose Kommunikation mit dem Endgerät (26) oder dem Weitverkehrsnetz (28) umfasst, um einen Zugangspunkt des Drahtlosnetzes (29) zu bilden, wobei das Verfahren umfasst:
- Ansteuern der Funkschnittstelle (31) zum Empfangen (41) eines Signals an der Funkschnittstelle (31),
- Prüfen (42), ob das empfangene Signal ein Steuersignal ist, und in diesem Fall Ansteuern (43) des Leuchtmittels (1) in Abhängigkeit von dem empfangenen Signal,
- Prüfen (44), ob das empfangene Signal eine Statusabfrage ist, und in diesem Fall Ansteuern der Funkschnittstelle (31) zum Senden (45) einer Statusinformation des Leuchtmittels (1) in Abhängigkeit von dem empfangenen Signal, und
- Prüfen, ob das empfangene Signal zwischen dem Endgerät (26) und einem Weitverkehrsnetz (28) zu übertragende Daten enthält, und in diesem Fall Ansteuern der Funkschnittstelle (31) zum Weiterleiten (46) der Daten an wenigstens einen weiteren Knoten (27) des Drahtlosnetzes (29).

11. Verfahren nach Anspruch 10, wobei das Verfahren weiterhin umfasst:
Empfangen von Daten von dem Weitverkehrsnetz (28) über die Funkschnittstelle (31); und
Weiterleiten der Daten an das Endgerät (26).

## Claims

1. An illuminating means, comprising
at least one light-emitting diode (2),
a communication device (5), which comprises a radio interface (31) for a wireless communication with a terminal (26), in order to form an access point of a wireless network (29), and
a control device (6; 34), which is connected to the radio interface (31), wherein the control device (6; 34) is configured to
- control the radio interface (31) for receiving (41) a signal at the radio interface (31),
- check (42), whether the received signal is a control signal, and in this case to control (43) the illuminating means (1) in dependence on the received signal,
- check (44), whether the received signal is a status query, and in this case control the radio interface (31) for sending (45) status information of the illuminating means (1) in dependence on the received signal, and
- check, whether the received signal contains data to be transmitted between the terminal (26) and a wide area network (28), and in this case control the radio interface (31) for forwarding (46) the data to at least one further node (27) of the wireless network (29).

2. The illuminating means according to Claim 1,
wherein the meshed wireless network (29) is a meshed wireless local area network.

3. The illuminating means according to Claim 1 or Claim 2,
wherein the communication device (5) is configured, in order to forward the data to the at least one further node (27) of the wireless network (29), so that the data are forwarded to a wide area network (28).

4. The illuminating means according to any one of the preceding claims, comprising a circuit board (10),
wherein the radio interface (31) comprises an antenna (31), which is arranged on a surface (11) of the circuit board (10), on which a light-emitting diode (2) of the at least one light-emitting diode (2) is arranged.

5. The illuminating means according to any one of the preceding claims,
wherein the control device (6; 34) is configured, in order to control or to regulate a brightness and/or a color of light emitted by the illuminating means (1) depending on the control signal received at the radio interface (31).

6. The illuminating means according to any one of the preceding claims,
wherein the illuminating means (1) is an LED module or an LED lamp.

7. A system, comprising
a wireless network (29) having a plurality of nodes (21-23, 27), wherein at least one of the nodes (21-23) comprises an illuminating means (1) according to any one of Claims 1 to 6, and
a terminal (26), which is configured for a wireless communication with the radio interface (31) of the illuminating means (1).

8. The system according to Claim 7,
wherein the wireless network (29) is a meshed wireless local area network.

9. The system according to Claim 7 or Claim 8, comprising
a wide area network (28),
wherein the illuminating means (1) is configured, in order to make possible a communication between the terminal (26) and the wide area network (28).

10. A method for communication between a wireless network (29) and a terminal (26) or a wide area network (28) using an illuminating means (1; 21), which comprises at least one light-emitting diode (2) and a communication device (5) with a radio interface (31) for a wireless communication with the terminal (26) or the wide area network (28), in order to form an access point of the wireless network (29), wherein the method comprises:
- Control of the radio interface (31) for receiving (41) a signal at the radio interface (31),
- checking (42), whether the received signal is a control signal, and in this case control (43) of the illuminating means (1) in dependence on the received signal,
- checking (44), whether the received signal is a status query, and in this case control of the radio interface (31) for sending (45) status information of the illuminating means (1) in dependence on the received signal, and
- checking, whether the received signal contains data to be transmitted between the terminal (26) and a wide area network (28), and in this case control of the radio interface (31) for forwarding (46) the data to at least one further node (27) of the wireless network (29).

11. The method according to Claim 10, wherein the method furthermore comprises:
Receiving data from the wide area network (28) via the radio interface (31) and forwarding the data to the terminal (26).

## Revendications

1. Moyen d'éclairage comprenant
au moins une diode électroluminescente (2),
un dispositif de communication (5), qui comprend une interface radio (31) pour une communication sans fil avec un terminal (26), afin de créer un point d'accès d'un réseau sans fil (29) et
un dispositif de commande (6 ; 34), qui est relié avec l'interface radio (31), le dispositif de commande (6 ; 34) étant conçu pour
- contrôle l'interface radio (31) pour la réception (41) d'un signal au niveau de l'interface radio (31),
- vérification (42) si le signal reçu est un signal de contrôle et si c'est le cas, contrôle (43) du moyen d'éclairage (1) en fonction du signal reçu,
- vérification (44) si le signal reçu est une demande d'état et si c'est le cas, contrôle de l'interface radio (31) pour l'émission (45) d'une information d'état du moyen d'éclairage (1) en fonction du signal reçu et
- vérification si le signal reçu contient des données à transmettre entre le terminal (26) et un réseau longue distance (28) et si c'est le cas, contrôle de l'interface radio (31) pour la transmission (46) des données à au moins un autre nœud (27) du réseau sans fil (29).

2. Moyen d'éclairage selon la revendication 1,
le réseau sans fil maillé (29) étant un réseau local sans fil maillé.

3. Moyen d'éclairage selon la revendication 1 ou la revendication 2,
le dispositif de communication (5) étant conçu afin de transmettre les données à l'au moins un autre nœud (27) du réseau dans fil (29) de façon à ce que les données soient transmises à un réseau longue distance (28).

4. Moyen d'éclairage selon l'une des revendications précédentes, comprenant une platine (10),
l'interface radio (31) comprenant une antenne (31) qui est disposée sur une surface (11) de la platine (10), sur laquelle est disposée une diode électroluminescente (2) de l'au moins une diode électroluminescente (2).

5. Moyen d'éclairage selon l'une des revendications précédentes,
le dispositif de commande (6 ; 34) étant conçu pour contrôler ou pour réguler une luminosité et/ou une couleur de la lumière émise par le moyen d'éclairage (1) en fonction du signal de commande reçu au niveau de l'interface radio (31).

6. Moyen d'éclairage selon l'une des revendications précédentes,
le moyen d'éclairage (1) étant un module LED ou une lampe LED.

7. Système comprenant
un réseau sans fil (29) avec une pluralité de nœuds (21-23, 27), au moins un des nœuds (21-23) comprenant un moyen d'éclairage (1) selon l'une des revendications 1 à 6 et
un terminal (26), qui est conçu pour une communication sans fil avec l'interface radio (31) du moyen d'éclairage (1).

8. Système selon la revendication 7,
le réseau sans fil (29) étant un réseau local sans fil maillé.

9. Système selon la revendication 7 ou 8, comprenant
un réseau longue distance (28)
le moyen d'éclairage (1) étant conçu pour permettre une communication entre le terminal (26) et le réseau longue distance (28).

10. Procédé de communication entre un réseau sans fil (29) et un terminal (29) ou un réseau longue distance (28) à l'aide d'un moyen d'éclairage (1 ; 21), qui comprend au moins une diode électroluminescente (2) et un dispositif de communication (5) avec une interface radio (31) pour une communication sans fil avec le terminal (26) ou le réseau longue distance (28), afin de créer un point d'accès du réseau sans fil (29), ce procédé comprenant :
- le contrôle de l'interface radio (31) pour la réception (41) d'un signal au niveau de l'interface radio (31),
- la vérification (42) si le signal reçu est un signal de contrôle et si c'est le cas, contrôle (43) du moyen d'éclairage (1) en fonction du signal reçu,
- la vérification (44) si le signal reçu est une demande d'état et si c'est le cas, contrôle de l'interface radio (31) pour l'émission (45) d'une information d'état du moyen d'éclairage (1) en fonction du signal reçu et
- vérification si le signal reçu contient des données à transmettre entre le terminal (26) et un réseau longue distance (28) et si c'est le cas, contrôle de l'interface radio (31) pour la transmission (46) des données à au moins un autre nœud (27) du réseau sans fil (29).

11. Procédé selon la revendication 10, ce procédé comprenant en outre :
la réception de données en provenance du réseau longue distance (28) par l'intermédiaire de l'interface radio (31) ; et
transmission des données au terminal (26).
